# FASCICULE DE BREVET EUROPEEN

(11) **EP 3 928 107 B1**
(45) Date de publication et mention de la délivrance du brevet: **20.03.2024**
(21) Numéro de dépôt: 19848809.0
(22) Date de dépôt: 20.12.2019
(51) Int. Cl.: G01R 31/36, G01R 31/389

(54) **PROCÉDÉ DE DIAGNOSTIC D'UNE BATTERIE D'UN VÉHICULE AUTOMOBILE**
VERFAHREN ZUR DIAGNOSE EINER BATTERIE EINES KRAFTFAHRZEUGS
METHOD FOR DIAGNOSING A BATTERY OF A MOTOR VEHICLE

(30) Priorité: 21.02.2019 FR 1901726
(43) Date de publication de la demande: 29.12.2021
(73) Titulaire: Stellantis Auto SAS, 78300 Poissy (FR)
(72) Inventeur: PERSEVAL, Herve, 91310 Montlhery (FR); BOUCLY, Bernard, 78150 Le Chesnay (FR); MONDOLONI, Christian, 78180 Montigny le Bretonneux (FR)
(86) Numéro de dépôt international: PCT/FR2019/053248
(87) Numéro de publication internationale: WO 2020/169891

(56) Documents cités:
- FR-A1- 3 044 099
- US-A1- 2012 187 917
- US-A1- 2018 147 942

## Description

L'invention a trait à un procédé de diagnostic d'une batterie d'un véhicule automobile, et plus particulièrement au diagnostic d'une batterie d'un véhicule configuré pour pouvoir rouler sans requérir la délivrance d'une puissance importante par ladite batterie.

Les véhicules automobiles, qu'ils soient à motorisation thermique, électrique ou hybride thermique/électrique, comprennent généralement un réseau électrique dit de bord permettant d'alimenter au moins un consommateur du véhicule.

Ce consommateur peut aussi bien participer au confort des passagers du véhicule, comme lorsqu'il s'agit d'une ventilation de l'habitacle du véhicule automobile, qu'à la sécurité des passagers du véhicule, comme lorsqu'il s'agit d'une aide au freinage du véhicule automobile.

Lorsque le consommateur participe à la sécurité des passagers la capacité de ladite batterie à fournir une puissance suffisante pour faire fonctionner correctement ledit consommateur doit être vérifiée à chaque nouvelle utilisation du véhicule automobile ou de façon périodique durant l'utilisation du véhicule.

Hors, pour certains véhicules à motorisation hybride ou à motorisation électrique, une phase de roulage du véhicule peut être réalisée en utilisant uniquement la source d'énergie issue du groupe motopropulseur comprenant un moteur électrique et un générateur ou une batterie dite de puissance. Le générateur ou la batterie de puissance sont couplés audit moteur électrique par le biais, par exemple, d'un convertisseur de puissance électrique (DCDC) afin de réaliser cette phase de roulage sans requérir la délivrance d'une puissance importante par la batterie du réseau de bord.

Ainsi, dans certains véhicules à motorisation hybride ou à motorisation électrique, la capacité de la batterie du réseau de bord à fournir une puissance suffisante pour faire fonctionner correctement le consommateur du réseau de bord ne peut pas être vérifiée avant ou pendant la phase de roulage du véhicule autrement qu'à l'instant de la sollicitation du ou des consommateurs. Ceci est d'autant plus problématique si le ou les consommateurs en question participent à des fonctions de sécurité comme le freinage, l'immobilisation, l'assistance de direction ou encore le contrôle de stabilité du véhicule.

Un tel comportement ne se retrouve pas dans un véhicule à motorisation thermique puisque la batterie du réseau de bord alimente, avant roulage du véhicule, un démarreur du moteur thermique qui requiert une puissance suffisante pour vérifier la capacité de ladite batterie à faire fonctionner correctement les autres consommateurs du réseau de bord.

Le document US 2018/147942 A1 décrit un dispositif de détermination d'état et un procédé de détermination d'état de batterie auxiliaire permettant de déterminer l'état d'une batterie auxiliaire fournie séparément d'une batterie de conduite servant de source d'énergie électrique pour un moteur d'entraînement d'un véhicule.

Le document FR-A1-3044099 décrit un diagnostic d'une batterie d'un premier réseau électrique d'un véhicule automobile, le premier réseau comprenant également un premier organe de mesure et un consommateur. Un second organe de mesure est couplé audit premier réseau électrique et isole ce premier réseau d'un second réseau électrique.

Le diagnostic de la batterie est réalisé par comparaison d'une mesure d'un paramètre de fonctionnement de la batterie réalisée par le premier organe de mesure avec une mesure du même paramètre de fonctionnement de la batterie réalisée par le second organe de mesure.

Un tel diagnostic permet effectivement de réaliser un double diagnostic de la batterie permettant de contrôler la capacité de la batterie à fournir une puissance importante même lorsque la mise en roulage du véhicule automobile ne nécessite pas la délivrance d'une telle puissance par la batterie du premier réseau.

Cependant, un tel diagnostic nécessite l'utilisation de plusieurs organes de mesures grevant le poids du véhicule automobile, l'encombrement de son réseau électrique ainsi que son prix de fabrication.

L'objectif de l'invention est de proposer un procédé de diagnostic d'état d'une batterie d'un véhicule automobile ne requérant pas la délivrance d'une puissance importante par ladite batterie pour pouvoir rouler tout en garantissant en début, en fin et/ou pendant le roulage un niveau de sécurité prédéfini en fonction du niveau d'équipement du véhicule en partant d'une définition technique d'entrée de gamme en terme d'assistance à la conduite jusqu'au niveau défini dans le standard des véhicules autonomes et tout en permettant la fabrication d'un véhicule plus léger, moins couteux et moins volumineux que ceux de l'art antérieur.

A cet effet, il est proposé, en premier lieu, un procédé de diagnostic d'état d'une batterie d'un réseau électrique d'un véhicule automobile, le réseau comprenant un consommateur alimenté en courant électrique continu par ladite batterie et par un convertisseur de puissance couplé à une chaîne de traction du véhicule et au réseau, le procédé comprenant une mesure d'au moins un paramètre de fonctionnement de la batterie pendant une décharge de la batterie et une comparaison dudit paramètre de fonctionnement mesuré avec un seuil de diagnostic d'état prédéterminé, le procédé comprenant, avant ladite mesure, une décharge d'initialisation de la batterie puis une activation d'initialisation du convertisseur à une tension de sortie supérieure ou égale à une tension requise pour alimenter le consommateur mettant fin à la décharge d'initialisation de la batterie.

Un tel procédé de diagnostic permet ainsi grâce à la décharge d'initialisation et à l'activation d'initialisation d'annuler l'effet de polarisation de la batterie afin d'obtenir une mesure utilisable pour contrôler l'état de la batterie du véhicule. Le procédé permet d'assurer ce diagnostic de la batterie alors que le véhicule roule ou avant une phase de roulage sans pour autant que le consommateur du réseau ne requière la délivrance d'une puissance importante par la batterie. Le procédé n'ayant besoin que d'une seule mesure permet également la fabrication d'un véhicule plus léger, moins couteux et moins volumineux que ceux de l'art antérieur.

De plus, l'annulation de l'effet de polarisation de la batterie permet d'améliorer les résultats du contrôle en particulier au sens de la robustesse et de la répétabilité des résultats.

L'état de la batterie comprend, par exemple, les paramètres d'état de charge, d'état de santé et de résistance interne.

Diverses caractéristiques supplémentaires peuvent être prévues, seules ou en combinaison :
- le au moins un paramètre de fonctionnement de la batterie mesuré est un couple comportant une tension aux bornes de la batterie et une intensité d'un courant circulant dans la branche du réseau comportant la batterie et la comparaison dudit paramètre de fonctionnement est réalisée par calcul d'une résistance interne de décharge de la batterie en divisant ladite tension par ladite intensité ;
- ladite décharge d'initialisation et ladite activation d'initialisation sont réalisées suite à une demande d'accès au véhicule automobile ou à une demande de mise en action du véhicule automobile ;
- le procédé comprend, après l'activation d'initialisation du convertisseur, plusieurs mesures dudit au moins un paramètre de fonctionnement de la batterie pendant des décharges successives de la batterie et, entre chaque décharge, une activation du convertisseur à une tension de sortie supérieure ou égale à la tension requise pour alimenter le consommateur, une telle comparaison étant réalisée après chaque décharge, la comparaison la plus défavorable étant prise en compte pour diagnostiquer l'état de la batterie ;
- la ou les décharges de la batterie et/ou la ou les activations du convertisseur durent entre 50 millisecondes et 250 millisecondes ;
- le procédé comprend, avant ladite décharge d'initialisation et ladite activation d'initialisation, une alimentation originelle en courant continu du réseau par le convertisseur de puissance puis une comparaison d'une intensité du courant délivré par le convertisseur avec un seuil de diagnostic originel prédéterminé, le seuil de diagnostic originel étant supérieur ou égal à la tension requise pour alimenter le consommateur, ladite comparaison d'intensité conditionnant la réalisation des étapes suivantes ;
- le procédé comprend, en fonction du résultat de la comparaison du paramètre de fonctionnement de la batterie mesuré avec le seuil de diagnostic d'état, un classement à la suite duquel la batterie est considérée comme en bon état, à régénérer ou à recycler ;
- le procédé comprend une validation du résultat de ladite comparaison en vérifiant qu'une intensité d'un courant circulant dans le consommateur est égale à la somme d'une intensité du courant délivré par le convertisseur de puissance et de l'intensité du courant circulant dans la batterie ;
- le procédé comprend, après la comparaison du paramètre de fonctionnement de la batterie mesuré avec le seuil de diagnostic d'état, une indication du résultat de ladite comparaison au conducteur du véhicule automobile.

Il est proposé, en second lieu, un véhicule automobile à motorisation électrique ou à motorisation hybride thermique/électrique, le véhicule comprenant un premier réseau électrique, un deuxième réseau électrique et un convertisseur de puissance continu/continu couplant le premier réseau et le deuxième réseau, le premier réseau comportant une batterie et au moins un consommateur alimenté en courant électrique continu par ladite batterie et/ou par le convertisseur de puissance, le véhicule automobile comprenant un système mettant en oeuvre un procédé de diagnostic de la batterie tel que précédemment décrit.

L'invention sera mieux comprise, et d'autres buts, caractéristiques, détails et avantages de celle-ci apparaîtront plus clairement dans la description explicative qui va suivre faite en référence aux dessins annexés donnés uniquement à titre d'exemple illustrant un mode de réalisation de l'invention et dans lesquels :
[Fig. 1] - la figure 1 est un schéma d'un convertisseur de puissance couplé à un réseau électrique comprenant une batterie et un consommateur ;
[Fig. 2] - la figure 2 illustre des courbes représentant une intensité d'un courant circulant dans la batterie en fonction du temps et une tension aux bornes du convertisseur de puissance en fonction du temps.

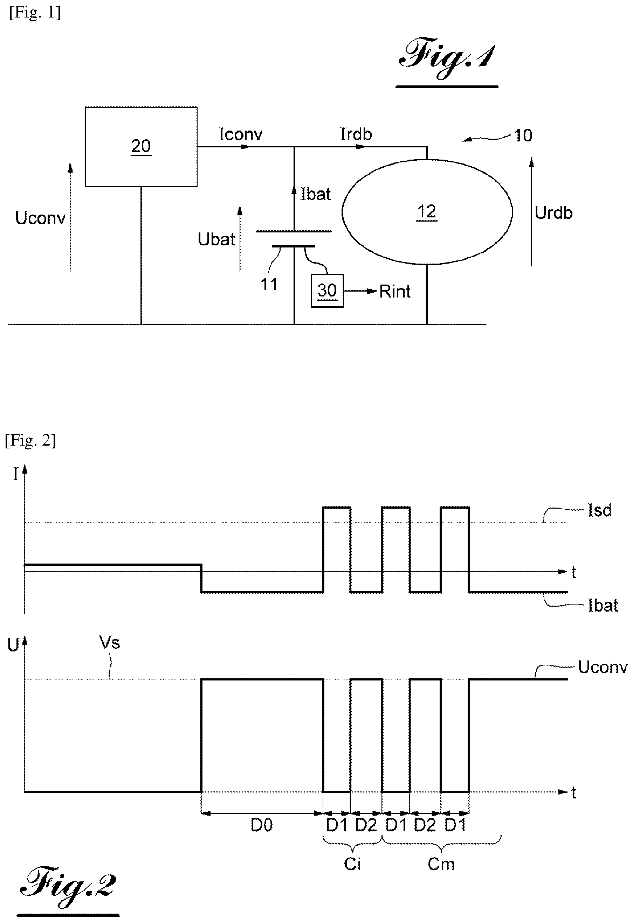

La figure 1 représente un réseau 10 électrique comprenant une batterie 11 et au moins un consommateur 12.

Un convertisseur 20 de puissance continu/continu couple le réseau 10 à un deuxième réseau non représenté.

Selon un mode de réalisation, le réseau 10 et/ou ledit deuxième réseau sont couplés à une chaîne de traction du véhicule.

Selon un mode de réalisation, le réseau 10 électrique appartient à un véhicule automobile.

Selon un mode de réalisation, le véhicule automobile est à motorisation électrique ou à motorisation hybride thermique/électrique.

Le convertisseur 20 de puissance est configuré pour recharger la batterie 11 et/ou alimenter le consommateur 12 en énergie électrique.

Selon un mode de réalisation, le réseau 10 électrique est adapté à la circulation d'un courant ayant une tension d'environ 12 Volts.

Selon un mode de réalisation, le deuxième réseau est adapté à la circulation d'un courant ayant une tension plus élevée que la tension du réseau 10 auquel appartient ladite batterie 11.

La figure 2 comprend, de haut en bas :
- un graphique représentant une intensité Ibat d'un courant circulant dans la batterie 11 en fonction du temps t,
- un graphique représentant une tension Uconv de sortie du convertisseur 20 de puissance en fonction du temps t.

Comme représenté sur la figure 2, le convertisseur 20 de puissance est apte à être activé afin de délivrer un courant électrique ayant une tension Uconv de sortie non nulle, par exemple égale à 12,8 Volts.

Lorsque le convertisseur 20 de puissance est actif, le courant délivré par celui-ci permet de recharger la batterie 11 et d'alimenter le consommateur 12 du réseau 10 électrique. Une telle recharge est représentée sur la figure 2 par une intensité Ibat du courant circulant dans la batterie 11 négative.

Comme représenté sur la figure 2, le convertisseur 20 de puissance est apte à être inactivé afin de ne délivrer aucun courant électrique.

Selon un mode de réalisation non représenté, l'inactivation du convertisseur 20 de puissance n'est pas complète de sorte que le convertisseur 20 délivre un courant électrique ayant une tension Uconv de sortie inférieure à la tension Urdb requise pour alimenter le consommateur 12 du réseau 10 électrique par exemple égale à 10,5 Volts (valeur ajustable entre 9,5 Volts et 10,5 Volts). Ainsi, la batterie 11 se décharge pour maintenir une tension Urdb dans le réseau 10 électrique suffisante pour alimenter le consommateur 12 dans la situation où la batterie 11 est en capacité de le réaliser. Dans le cas où la batterie 11 n'est pas en capacité de le réaliser, la tension Urdb minimale dans le réseau 10 électrique est garantie par le convertisseur 20 de puissance. Dans cette dernière situation la batterie 11 est déclarée défaillante.

Lorsque le convertisseur 20 de puissance est inactif (i.e. ne délivrant aucun courant électrique ou délivrant un courant ayant une tension Uconv de sortie inférieure à la tension Urdb requise pour alimenter le consommateur 12 a un niveau de tension minimal permettant de garantir la performance nominale du consommateur 12), la batterie 11 se décharge pour délivrer un courant électrique permettant d'alimenter le consommateur 12 du réseau 10 électrique. Une telle décharge est représentée sur la figure 2 par une intensité Ibat du courant circulant dans la batterie 11 positive.

Selon un mode de réalisation, le au moins un consommateur 12 est un dispositif appartenant à l'assistance électrique de direction du véhicule automobile, au moyen de freinage du véhicule automobile, au moyen de démarrage du moteur thermique du véhicule automobile et/ou au moyen d'éclairage ou de signalisation du véhicule automobile.

Un procédé de diagnostic d'état de la batterie 11 comprend une phase d'alimentation originelle du réseau 10 de bord par le convertisseur 20 de puissance.

Cette phase d'alimentation originelle recharge la batterie 11 et alimente le consommateur 12.

Selon un mode de réalisation, cette alimentation originelle est initiée par une ouverture d'une porte du véhicule automobile. Selon des modes de réalisation différents, cette alimentation originelle est initiée par la mise en contact du véhicule.

Selon le mode de réalisation illustré, l'alimentation originelle est réalisée pendant une durée D0.

Selon le mode de réalisation illustré, l'alimentation originelle est réalisée à une tension Vs. La tension Vs est par exemple égale à 12,8 Volts par exemple ajustable en fonction de la tension de repos de la batterie 11 dépendante de la technologie de la batterie 11.

Selon un mode de réalisation différent, l'état de charge de la batterie 11 est mesuré avant de mettre en oeuvre le procédé de diagnostic.

Après cette alimentation originelle, le procédé comprend une comparaison de la valeur d'une intensité Iconv du courant délivré par le convertisseur 20 avec un seuil Isd de diagnostic originel prédéterminé.

Selon un mode de réalisation, le seuil Isd de diagnostic originel est supérieur ou égal au besoin du consommateur 12 de sorte que la batterie 11 ne se décharge pas.

Selon un mode de réalisation différent, après cette alimentation originelle, le procédé comprend une comparaison de la différence de la valeur de l'intensité Iconv du courant délivré par le convertisseur 20 par la valeur de l'intensité Ibat du courant délivré par la batterie 11 avec un seuil Isd de diagnostic originel prédéterminé par exemple égal à 70 Ampères.

Si la comparaison révèle que la valeur de l'intensité Iconv du courant délivré par le convertisseur 20 ou de ladite différence est supérieure à leur seuil respectif, le procédé comprend, selon le mode de réalisation représenté, un cycle Ci d'initialisation comportant une inactivation du convertisseur 20 de puissance pendant une durée D1, comme représenté sur la figure 2.

Selon un mode de réalisation, la durée D1 est environ égale à 200 millisecondes.

L'inactivation du convertisseur 20 de puissance force la batterie 11 à se décharger pour alimenter le consommateur 12. Ladite inactivation du convertisseur 20 de puissance du cycle Ci d'initialisation n'étant pas forcément complète, de sorte que le convertisseur 20 délivre un courant électrique assez faible pour que la batterie 11 se décharge, peut ainsi être appelée décharge d'initialisation de la batterie (11).

Suite à cette inactivation, le cycle Ci d'initialisation comprend une activation du convertisseur 20 de puissance pendant une durée D2, comme représenté sur la figure 2.

Selon un mode de réalisation, la durée D2 est environ égale à 200 millisecondes.

L'activation du convertisseur 20 alimente le consommateur en énergie électrique sous une tension maximale qui est par exemple la tension de polarisation de la batterie 11 de 12,8 Volts dans le but de ne pas la polariser avant d'engager le cycle suivant.

Ce cycle Ci d'initialisation permet d'annuler l'effet de polarisation de la batterie 11.

Le procédé comprend ensuite au moins un cycle Cm d'évaluation, chaque cycle Cm d'évaluation comportant une inactivation pendant la durée D1 et une activation pendant la durée D2 du convertisseur 20.

Comme représenté sur la figure 2, lors du dernier cycle Cm d' évaluation, l' activation n'est pas contrainte par la durée D2.

Selon un mode de réalisation différent, les durées d'inactivation et d'activation sont différentes entre elles et/ou entre le cycle Ci d'initialisation et le cycle Cm d'évaluation.

A chaque cycle Cm d'évaluation, le procédé comprend, lors de l'inactivation du convertisseur 20 de puissance, une mesure d'une tension Ubat aux bornes de la batterie 11 et de l'intensité Ibat du courant circulant dans la batterie 11.

Après chaque mesure le procédé comprend un calcul d'une résistance Rint interne de décharge de la batterie 11 en divisant la tension Ubat aux bornes de la batterie 11 par l'intensité Ibat du courant circulant dans la batterie 11 mesurées. La résistance Rint interne de décharge représente la capacité de la batterie 11 à fournir de la puissance.

Selon un mode de réalisation, les mesures de la tension Ubat aux bornes de la batterie 11 et de l'intensité Ibat du courant circulant dans la batterie 11 est réalisée à chaque milliseconde (soit à une fréquence de 1 kilohertz). Pour chaque cycle Cm d'évaluation du convertisseur 20 une moyenne de toutes les tensions Ubat et intensités Ibat mesurées ou une moyenne de toutes les résistances Rint internes calculées est faite.

Selon un mode de réalisation, le ou les mesures de la tension Ubat aux bornes de la batterie 11 et de l'intensité Ibat du courant circulant dans la batterie 11 et le ou les calculs de la résistance Rint interne de décharge sont réalisés à partir d'un gradient d'intensité du courant circulant dans la batterie 11 en une durée donnée supérieur à un seuil prédéterminé. Ce seuil est par exemple égal à 70 Ampères pour une durée par exemple de 5 millisecondes.

Cette résistance Rint interne ou cette résistance Rint interne moyenne calculée à chaque cycle Cm d'évaluation est ensuite comparée, par exemple dans un abaque, à au moins un seuil de diagnostic d'état de santé de la batterie 11 prédéterminé.

Selon un mode de réalisation, en fonction du résultat de la comparaison de la résistance Rint interne de la batterie 11 calculée avec le au moins un seuil de diagnostic d'état de santé, la batterie 11 est considérée comme en bon état, à régénérer ou à recycler signifiant par exemple que la capacité de la batterie 11 à fournir la puissance est considérée comme nominale, dégradée temporairement, dégradée ou encore incapable.

Selon un mode de réalisation, la comparaison amenant au résultat le plus défavorable est prise en compte.

Selon un mode de réalisation différent, une moyenne des résultats des comparaisons est réalisée.

La régénération de la batterie 11 permet, dans le meilleur des cas, de lui redonner des caractéristiques fonctionnelles sensiblement identiques aux caractéristiques nominales d'une batterie neuve.

Le résultat de cette comparaison est envoyé à un système de gestion d'énergie électrique.

Selon un mode de réalisation, le procédé comprend ensuite un traitement du résultat de la comparaison par le système de gestion d'énergie électrique.

Selon un mode de réalisation, dans le cas où le résultat ne permet pas d'atteindre le seuil de diagnostic prédéterminé, une information est générée permettant de reconfigurer des fonctions du véhicule notamment en limitant le niveau de courant maximum de certaines fonctions comme par exemple la fonction d'assistance de direction.

Selon un mode de réalisation, le procédé comprend une indication du résultat, par exemple, au conducteur du véhicule automobile de sorte qu'il puisse adapter l'usage de son véhicule en fonction du niveau de gravité de l'information portée à sa connaissance.

Selon un mode de réalisation, cette information est enregistrée et datée dans le but de pouvoir par exemple être analysée par le service après-vente du constructeur du véhicule et/ou servir de preuve objective lors d'un recours juridique si un accident survient en concomitance à l'apparition de l'information portée à la connaissance du conducteur, afin d'éclairer les diverses responsabilités associées à cet accident.

Selon un mode de réalisation, pendant tous les cycles Cm d'évaluation il est vérifié qu'une intensité Irdb d'un courant circulant dans le consommateur 12 est égale à la somme de l'intensité Iconv du courant délivré par le convertisseur 20 de puissance et de l'intensité Ibat du courant circulant dans la batterie 11.

Selon le mode de réalisation représenté, les mesures de la tension Ubat aux bornes de la batterie 11 et de l'intensité Ibat du courant circulant dans la batterie 11 sont réalisées par un Boitier d'Etat de Charge de Batterie (BECB) 30 présent sur tous les véhicules.

Selon un mode de réalisation, il est vérifié que l'impédance aux bornes du consommateur 12 est inférieure à une impédance critique.

Un tel procédé de diagnostic de la batterie 11 d'un véhicule automobile permet ainsi, sans requérir la délivrance d'une puissance importante par ladite batterie 11 pour pouvoir rouler, la vérification de la capacité de la batterie 11 à fournir une puissance suffisante pour faire fonctionner correctement le consommateur 12.

Un tel procédé de diagnostic permet également la fabrication d'un véhicule plus léger, moins couteux et moins volumineux que ceux de l'art antérieur.

## Revendications

1. Procédé de diagnostic d'état d'une batterie (11) d'un réseau (10) électrique d'un véhicule automobile, le réseau (10) comprenant un consommateur (12) alimenté en courant électrique continu par ladite batterie (11) et par un convertisseur (20) de puissance couplé à une chaîne de traction du véhicule et au réseau (10), le procédé comprenant une mesure d'au moins un paramètre (Ubat, Ibat) de fonctionnement de la batterie (11) pendant une décharge de la batterie (11) et une comparaison dudit paramètre (Ubat, Ibat) de fonctionnement mesuré avec un seuil de diagnostic d'état prédéterminé, le procédé étant **caractérisé en ce qu'**il comprend, avant ladite mesure, une décharge d'initialisation de la batterie (11) puis une activation d'initialisation du convertisseur (20) à une tension (Uconv) de sortie supérieure ou égale à une tension (Urdb) requise pour alimenter le consommateur (12) mettant fin à la décharge d'initialisation de la batterie (11).

2. Procédé de diagnostic selon la revendication précédente, **caractérisé en ce que** le au moins un paramètre (Ubat, Ibat) de fonctionnement de la batterie (11) mesuré est un couple comportant une tension (Ubat) aux bornes de la batterie (11) et une intensité (Ibat) d'un courant circulant dans la branche du réseau (10) comportant la batterie (11) et **en ce que** la comparaison dudit paramètre (Ubat, Ibat) de fonctionnement est réalisée par calcul d'une résistance (Rint) interne de décharge de la batterie (11) en divisant ladite tension (Ubat) par ladite intensité (Ibat).

3. Procédé de diagnostic selon l'une quelconque des revendications précédentes, **caractérisé en ce que** ladite décharge d'initialisation et ladite activation d'initialisation sont réalisées suite à une demande d'accès au véhicule automobile ou à une demande de mise en action du véhicule automobile.

4. Procédé de diagnostic selon l'une quelconque des revendications précédentes, **caractérisé en ce qu'**il comprend, après l'activation d'initialisation du convertisseur (20), plusieurs mesures dudit au moins un paramètre (Ubat, Ibat) de fonctionnement de la batterie (11) pendant des décharges successives de la batterie (11) et, entre chaque décharge, une activation du convertisseur (20) à une tension (Uconv) de sortie supérieure ou égale à la tension (Urdb) requise pour alimenter le consommateur (12), une telle comparaison étant réalisée après chaque décharge, la comparaison la plus défavorable étant prise en compte pour diagnostiquer l'état de la batterie (11).

5. Procédé de diagnostic selon la revendication précédente, **caractérisé en ce que** la ou les décharges de la batterie (11) et/ou la ou les activations du convertisseur (20) durent entre 50 millisecondes et 250 millisecondes.

6. Procédé de diagnostic selon l'une quelconque des revendications précédentes, **caractérisé en ce qu'**il comprend, avant ladite décharge d'initialisation et ladite activation d'initialisation, une alimentation originelle en courant continu du réseau (10) par le convertisseur (20) de puissance puis une comparaison d'une intensité (Iconv) du courant délivré par le convertisseur (20) avec un seuil (Isd) de diagnostic originel prédéterminé, le seuil (Isd) de diagnostic originel étant supérieur ou égal à la tension (Urdb) requise pour alimenter le consommateur (12), ladite comparaison d'intensité conditionnant la réalisation des étapes suivantes.

7. Procédé de diagnostic selon l'une quelconque des revendications précédentes, **caractérisé en ce qu'**il comprend, en fonction du résultat de la comparaison du paramètre (Ubat, Ibat) de fonctionnement de la batterie (11) mesuré avec le seuil de diagnostic d'état, un classement à la suite duquel la batterie (11) est considérée comme en bon état, à régénérer ou à recycler.

8. Procédé de diagnostic selon l'une quelconque des revendications précédentes, **caractérisé en ce qu'**il comprend une validation du résultat de ladite comparaison en vérifiant qu'une intensité (Irdb) d'un courant circulant dans le consommateur (12) est égale à la somme d'une intensité (Iconv) du courant délivré par le convertisseur (20) de puissance et de l'intensité (Ibat) du courant circulant dans la batterie (11).

9. Procédé de diagnostic selon l'une quelconque des revendications précédentes, **caractérisé en ce qu'**il comprend, après la comparaison du paramètre (Ubat, Ibat) de fonctionnement de la batterie mesuré avec le seuil de diagnostic d'état, une indication du résultat de ladite comparaison au conducteur du véhicule automobile.

10. Véhicule automobile à motorisation électrique ou à motorisation hybride thermique/électrique, le véhicule comprenant un premier réseau (10) électrique, un deuxième réseau électrique et un convertisseur (20) de puissance continu/continu couplant le premier réseau (10) et le deuxième réseau, le premier réseau (10) comportant une batterie (11) et au moins un consommateur (12) alimenté en courant électrique continu par ladite batterie (11) et/ou par le convertisseur (20) de puissance, le véhicule automobile étant **caractérisé en ce qu'**il comprend un système mettant en oeuvre un procédé de diagnostic de la batterie (11) selon l'une quelconque des revendications précédentes.

## Patentansprüche

1. Verfahren zur Zustandsdiagnose einer Batterie (11) eines elektrischen Netzes (10) eines Kraftfahrzeugs, wobei das Netz (10) einen Verbraucher (12) umfasst, der von der Batterie (11) und einem Stromrichter mit elektrischem Gleichstrom versorgt wird (20), gekoppelt an eine Traktionskette des Fahrzeugs und an das Netzwerk (10), wobei das Verfahren eine Messung mindestens eines Parameters ( Ubat , Ibat ) des Betriebs der Batterie (11) während einer Entladung der Batterie (11) umfasst) und einen Vergleich des gemessenen Betriebsparameters ( Ubat , Ibat ) mit einem vorbestimmten Zustandsdiagnoseschwellenwert, wobei das Verfahren **dadurch gekennzeichnet ist, dass** es vor der Messung eine Initialisierungsentladung der Batterie (11) und dann eine Initialisierungsaktivierung des Wandlers umfasst (20) bei einer Ausgangsspannung ( Uconv ), die größer oder gleich einer Spannung ( Urdb ) ist, die zum Betreiben des Verbrauchers (12) erforderlich ist, wodurch die Initialisierungsentladung der Batterie (11) beendet wird.

2. Diagnoseverfahren nach dem vorhergehenden Anspruch, **dadurch gekennzeichnet, dass** der mindestens eine gemessene Betriebsparameter ( Ubat , Ibat ) der Batterie (11) ein Drehmoment ist, das eine Spannung ( Ubat ) an den Anschlüssen der Batterie (11) und eine Intensität umfasst ( Ibat ) eines in dem die Batterie (11) umfassenden Zweig des Netzes (10) zirkulierenden Stroms und dadurch, dass der Vergleich des Betriebsparameters ( Ubat , Ibat ) durch Berechnung eines Innenwiderstands ( Rint ) der Entladung erfolgt Batterie (11) durch Teilen der Spannung ( Ubat ) durch die Intensität ( Ibat ).

3. Diagnoseverfahren nach einem der vorhergehenden Ansprüche, **dadurch gekennzeichnet, dass** die Initialisierungsentladung und die Initialisierungsaktivierung nach einer Zugangsanfrage zum Kraftfahrzeug oder einer Aktivierungsanfrage des Kraftfahrzeugs durchgeführt werden.

4. Diagnoseverfahren nach einem der vorhergehenden Ansprüche, **dadurch gekennzeichnet, dass** es nach der Initialisierungsaktivierung des Wandlers (20) mehrere aufeinanderfolgende Messungen des mindestens einen Parameters (Ubat, Ibat ) des Betriebs der Batterie (11) umfasst Entladungen der Batterie (11) und zwischen jeder Entladung Aktivierung des Wandlers (20) bei einer Ausgangsspannung ( Uconv ), die größer oder gleich der zur Versorgung des Verbrauchers (12) erforderlichen Spannung ( Urdb ) ist, wie z Nach jeder Entladung wird ein Vergleich durchgeführt, wobei der ungünstigste Vergleich zur Diagnose des Batteriezustands berücksichtigt wird (11).

5. Diagnoseverfahren nach dem vorhergehenden Anspruch, **dadurch gekennzeichnet, dass** die Entladung(en) der Batterie (11) und/oder die Aktivierung(en) des Wandlers (20) zwischen 50 Millisekunden und 250 Millisekunden dauern.

6. Diagnoseverfahren nach einem der vorhergehenden Ansprüche, **dadurch gekennzeichnet, dass** es vor der Initialisierungsentladung und der Initialisierungsaktivierung eine ursprüngliche Gleichstromversorgung des Netzes (10) durch den Leistungswandler (20) und dann einen Vergleich einer Intensität umfasst ( Iconv ) des vom Wandler (20) gelieferten Stroms mit einer vorgegebenen ursprünglichen Diagnoseschwelle ( Isd ), wobei die ursprüngliche Diagnoseschwelle ( Isd ) größer oder gleich der zur Versorgung des Verbrauchers (12) erforderlichen Spannung ( Urdb ) ist, wobei der Intensitätsvergleich den Abschluss der folgenden Schritte bedingt.

7. Diagnoseverfahren nach einem der vorhergehenden Ansprüche, **dadurch gekennzeichnet, dass** es abhängig vom Ergebnis des Vergleichs des gemessenen Betriebsparameters ( Ubat , Ibat ) der Batterie (11) mit der Diagnosezustandsschwelle eine Klassifizierung umfasst Danach gilt die Batterie (11) als in gutem Zustand und muss regeneriert oder recycelt werden.

8. Diagnoseverfahren nach einem der vorhergehenden Ansprüche, **dadurch gekennzeichnet, dass** es eine Validierung des Ergebnisses des Vergleichs umfasst, indem überprüft wird, ob eine Intensität ( Irdb ) eines im Verbraucher (12) zirkulierenden Stroms gleich der Summe einer Intensität ist ( Iconv ) des vom Leistungswandler (20) gelieferten Stroms und die Intensität ( Ibat ) des in der Batterie (11) zirkulierenden Stroms.

9. Diagnoseverfahren nach einem der vorhergehenden Ansprüche, **dadurch gekennzeichnet, dass** es nach dem Vergleich des gemessenen Betriebsparameters ( Ubat , Ibat ) der Batterie mit dem Zustandsdiagnoseschwellenwert eine Anzeige des Ergebnisses des Vergleichs an den Fahrer des Fahrzeugs umfasst Kraftfahrzeug.

10. Kraftfahrzeug mit Elektromotor oder thermischem/elektrischem Hybridmotor, wobei das Fahrzeug ein erstes elektrisches Netzwerk (10), ein zweites elektrisches Netzwerk und einen DC/DC-Leistungswandler (20) umfasst, der das erste Netzwerk (10) und das zweite Netzwerk koppelt erstes Netzwerk (10), umfassend eine Batterie (11) und mindestens einen Verbraucher (12), der von der Batterie (11) und/oder vom Stromrichter (20) mit elektrischem Gleichstrom versorgt wird, wobei das Kraftfahrzeug **dadurch gekennzeichnet ist, dass** es Folgendes umfasst: ein System, das ein Batteriediagnoseverfahren (11) nach einem der vorhergehenden Ansprüche implementiert.

## Claims

1. Method for diagnosing the state of a battery (11) of an electrical network (10) of a motor vehicle, the network (10) comprising a consumer (12) supplied with direct electric current by said battery (11) and by a power converter (20) coupled to a traction chain of the vehicle and to the network (10), the method comprising a measurement of at least one parameter ( Ubat , Ibat ) of operation of the battery (11) during a discharge of the battery (11) and a comparison of said measured operating parameter ( Ubat , Ibat ) with a predetermined state diagnostic threshold, the method being **characterized in that** it comprises, before said measurement, an initialization discharge of the battery (11) then an initialization activation of the converter (20) at an output voltage ( Uconv ) greater than or equal to a voltage ( Urdb ) required to power the consumer (12) putting an end to the initialization discharge of the battery (11).

2. Diagnostic method according to the preceding claim, **characterized in that** the at least one operating parameter ( Ubat , Ibat ) of the battery (11) measured is a torque comprising a voltage ( Ubat ) at the terminals of the battery (11) and a intensity ( Ibat ) of a current circulating in the branch of the network (10) comprising the battery (11) and **in that** the comparison of said operating parameter ( Ubat , Ibat ) is carried out by calculating an internal resistance ( Rint ) discharge of the battery (11) by dividing said voltage ( Ubat ) by said intensity ( Ibat).

3. Diagnostic method according to any one of the preceding claims, **characterized in that** said initialization discharge and said initialization activation are carried out following a request for access to the motor vehicle or a request to activate the motor vehicle.

4. Diagnostic method according to any one of the preceding claims, **characterized in that** it comprises, after initialization activation of the converter (20), several measurements of said at least one parameter ( Ubat , Ibat ) of operation of the battery (11) during successive discharges of the battery (11) and, between each discharge, activation of the converter (20) at an output voltage ( Uconv ) greater than or equal to the voltage ( Urdb ) required to supply the consumer (12), such a comparison being carried out after each discharge, the most unfavorable comparison being taken into account to diagnose the state of the battery (11).

5. Diagnostic method according to the preceding claim, **characterized in that** the discharge(s) of the battery (11) and/or the activation(s) of the converter (20) last between 50 milliseconds and 250 milliseconds.

6. Diagnostic method according to any one of the preceding claims, **characterized in that** it comprises, before said initialization discharge and said initialization activation, an original direct current supply of the network (10) by the converter (20) power then a comparison of an intensity ( Iconv ) of the current delivered by the converter (20) with a predetermined original diagnostic threshold ( Isd ), the original diagnostic threshold ( Isd ) being greater than or equal to the voltage ( Urdb ) required to power the consumer (12), said intensity comparison conditioning the completion of the following steps.

7. Diagnostic method according to any one of the preceding claims, **characterized in that** it comprises, depending on the result of the comparison of the parameter ( Ubat , Ibat ) of operation of the battery (11) measured with the diagnostic threshold of state, a classification following which the battery (11) is considered to be in good condition, to be regenerated or recycled.

8. Diagnostic method according to any one of the preceding claims, **characterized in that** it comprises a validation of the result of said comparison by verifying that an intensity ( Irdb ) of a current circulating in the consumer (12) is equal to the sum of an intensity ( Iconv ) of the current delivered by the power converter (20) and the intensity ( Ibat) of the current circulating in the battery (11).

9. Diagnostic method according to any one of the preceding claims, **characterized in that** it comprises, after comparing the operating parameter ( Ubat , Ibat ) of the battery measured with the state diagnosis threshold, an indication of the result of said comparison to the driver of the motor vehicle.

10. Motor vehicle with electric motor or thermal/electric hybrid motor, the vehicle comprising a first electrical network (10), a second electrical network and a DC/DC power converter (20) coupling the first network (10) and the second network , the first network (10) comprising a battery (11) and at least one consumer (12) supplied with direct electric current by said battery (11) and/or by the power converter (20), the motor vehicle being **characterized in** which it comprises a system implementing a battery diagnostic method (11) according to any one of the preceding claims.
